# EUROPÄISCHE PATENTANMELDUNG

(11) **EP 1 496 398 A1**
(43) Veröffentlichungstag der Anmeldung: **12.01.2005**
(21) Anmeldenummer: 04015662.2
(22) Anmeldetag: 02.07.2004
(51) Int. Cl.: G03F 7/20, G01J 4/00

(54) **Vorrichtung zur polarisationsspezifischen Untersuchung, optisches Abbildungssystem und Kalibrierverfahren**

(30) Priorität: 05.07.2003 WO PCT/EP03/07203
(71) Anmelder: Carl Zeiss SMT AG, 73447 Oberkochen (DE)
(72) Erfinder: Wegmann, Ulrich, 89551 Königsbronn (DE); Mengel, Markus, 89522 Heidenheim (DE)
(74) Vertreter: Weller, Erich W.

(57) **Zusammenfassung**

Die Erfindung bezieht sich auf eine Vorrichtung zur polarisationsspezifischen Untersuchung eines optischen Systems mit einem Detektorteil, der Polarisationsdetektormittel zur Erfassung des Austritts-Polarisationszustands von aus dem optischen System austretender Strahlung (6) aufweist, auf ein zugehöriges optisches Abbildungssystem und auf ein Kalibrierverfahren für die Vorrichtung. Eine erfindungsgemäße Vorrichtung beinhaltet Polarisationsdetektormittel mit einer polarisierenden Gitterstruktur (4). Alternativ ist eine Vorrichtung zur Schnappschuss-Polarimetrie mit einem doppelbrechenden Element und nachgeschaltetem Polarisatorelement vorgesehen, das geeignet ist, auch nicht quasiparallele Strahlung ausreichend zu polarisieren. Verwendung z.B. zur Bestimmung der Beeinflussung des Polarisationszustands von UV-Strahlung durch ein Mikrolithographie-Projektionsobjektiv.

## Beschreibung

Die Erfindung bezieht sich auf eine Vorrichtung zur polarisationsspezifischen Untersuchung eines optischen Systems mit einem Detektorteil, der Polarisationsdetektormittel zur Erfassung des Austritts-Polarisationszustands von aus dem optischen System austretender Strahlung umfasst, auf ein optisches Abbildungssystem mit einer solchen Vorrichtung und auf ein zugehöriges Kalibrierverfahren.

Insbesondere kann eine solche Vorrichtung zur Bestimmung benutzt werden, wie ein optisches System den Polarisationszustand optischer Strahlung beeinflusst. Dazu sind verschiedene Vorrichtungstypen bekannt. Unter dem Begriff optisches System ist dabei jedwede Anordnung einer oder mehrerer Optikkomponenten zu verstehen, die einfallende optische Strahlung transmittieren und/oder reflektieren, insbesondere auch Linsen und damit aufgebaute Objektive. Unter dem Begriff optische Strahlung ist vorliegend eine beliebige elektromagnetische Strahlung zu verstehen, mit denen das untersuchte optische System beaufschlagt wird, z.B. sichtbares Licht oder UV-Strahlung. Besonders verbreitet sind Ellipsometrieverfahren und Ellipsometrievorrichtungen in diversen Ausprägungen. Zur Beschreibung des Polarisationszustandes sowie dessen Beeinflussung bzw. Änderung durch das optische System dienen geeignete Größen, wie die Stokes-Parameter, die Müller-Matrix, die Polarisationsmatrix und die Jones-Matrix. Für diesbezügliche Details kann auf die einschlägige Literatur verwiesen werden.

Zur Ermittlung der Abbildungsgüte von hochpräzis abbildenden Optiken können bekanntermaßen Wellenfrontsensoren eingesetzt werden, mit denen Abweichungen der bildseitigen Wellenfronten vom idealen Abbildungsverhalten sehr genau bestimmt werden können. Hierzu sind z.B. sogenannte Shearing-Interferometer im Gebrauch. Eine darauf basierende Wellenfronterfassungsvorrichtung ist in der Offenlegungsschrift DE 101 09 929 A1 offenbart. Diese Vorrichtung eignet sich insbesondere auch zur Bestimmung der Abbildungsqualität von Projektionsobjektiven mikrolithographischer Projektionsbelichtungsanlagen und beinhaltet Mittel zur Bereitstellung einer Wellenfrontquelle, z.B. mit einem Lichtleiter und einer an dessen Ausgang angeordneten Lochmaske, in der Objektebene des untersuchten optischen Abbildungssystems und ein Beugungsgitter in der zur Objektebene konjugierten Bildebene. Dem Beugungsgitter ist ein ortsauflösender Strahlungsdetektor nachgeschaltet, z.B. in Form eines CCD-Chips, wobei eine zwischenliegende Optik das vom Beugungsgitter erzeugte Interferogramm auf die Sensorfläche des Detektors abbildet. Diese Art von Wellenfrontsensorik kann das Abbildungssystem mit derselben Strahlung untersuchen, die vom Abbildungssystem in seinem normalen Betrieb verwendet wird. Dieser Wellenfrontsensortyp wird daher auch als Betriebsinterferometer (BIF) bezeichnet und kann insbesondere mit dem Abbildungssystem in einer Baueinheit integriert sein.

In der nicht vorveröffentlichten deutschen Patentanmeldung 102 17 242.0 wird eine Messvorrichtung beschrieben, die insbesondere eine derartige BIF-Vorrichtung sein kann und zur interferometrischen Vermessung eines optischen Abbildungssystems dient, das zur Abbildung eines an einer Maske vorgesehenen Nutzmusters in die Bildebene dient, wozu die Maske in der Objektebene angeordnet wird. Es wird vorgeschlagen, die Wellenfrontquelle für die interferometrische Vermessung durch ein zusätzlich zum Nutzmuster an der Maske ausgebildetes Messmuster zu realisieren.

Eine weitere, in der Praxis verwendete Methode der Wellenfronterfassung hochpräziser Abbildungssysteme stellt die Punktbeugungs-Interferometrie (Point-Diffraction-Interferometrie) dar, deren Grundprinzipien in der einschlägigen Fachliteratur beschrieben sind, siehe z.B. D. Malacara, "Optical Shop Testing", Kap. 3.7., John Wiley, New York, 1991. Spezielle Ausführungen sind in den Patentschriften US 6.344.898 B1 und US 6.312.373 und den Offenlegungsschriften JP 11-142291 und WO 02/42728 angegeben. Weitere benutzte Methoden zur Bestimmung bzw. Korrektur von Abbildungsfehlern hochpräziser Abbildungssysteme sind z.B. das Shack-Hartmann-Verfahren und das von der Firma Litel Instruments benutzte, sogenannte Litel-Verfahren, siehe zu letzterem z.B. die Patentschriften US 5.392.119, US 5.640.233, US 5.929.991 und US 5.978.085. Diese interferometrischen und nicht-interferometrischen Vermessungsverfahren können insbesondere zur Aberrationsbestimmung von Projektionsobjektiven mikrolithographischer Projektionsbelichtungsanlagen benutzt werden.

Bei modernen hochpräzisen Abbildungssystemen hoher numerischer Apertur, wie sie z.B. als mikrolithographische Projektionsobjektive eingesetzt werden, ist der Einfluss des Abbildungssystems auf den Polarisationszustand der eingesetzten Strahlung kaum mehr zu vernachlässigen. So ergeben sich z.B. polarisationsbedingte Auswirkungen auf die Abbildungsqualität durch Doppelbrechung bei Linsen aus Calciumfluorid, wie sie häufig für kurze Wellenlängen verwendet werden, und durch Polarisationseffekte an Umlenkspiegeln. Es besteht daher ein Bedarf, die Beeinflussung des Polarisationszustands von optischen Abbildungssystemen hoher Apertur möglichst gut quantitativ bestimmen zu können, um daraus Rückschlüsse auf die polarisationsabhängige Abbildungsqualität zu ziehen.

Verschiedene Vorrichtungen zur Bestimmung der Polarisationszustandsbeeinflussung durch ein optisches System und dafür geeignete Polarisationsanalysatoranordnungen sind in der nicht vorveröffentlichten, älteren deutschen Patentanmeldung 103 04 822.7 beschrieben, deren Inhalt hiermit in vollem Umfang durch Verweis aufgenommen wird. Mit der dort beschriebenen Vorrichtung und dem dort beschriebenen Verfahren kann z.B. die phasenreduzierte oder vollständige Jones-Matrix eines untersuchten optischen Abbildungssystems, insbesondere auch von hochaperturigen Mikrolithographie-Projektionsobjektiven, pupillenaufgelöst bestimmt werden. Die Polarisationsdetektormittel des Detektorteils, der auf der Bildseite des untersuchten optischen Abbildungssystems angeordnet wird, weisen dort eine Kompensator-Polarisatoreinheit, typischerweise in Form einer λ/4-Platte, mit nachfolgendem Polarisationsanalysatorelement, typischerweise in Form eines Polarisationsstrahlteilerelements, und eine vorgeschaltete, kollimierende Optik auf, um das aus dem untersuchten optischen Abbildungssystem austretende Aperturstrahlenbündel in ein für das Polarisationsanalysatorelement benötigtes Parallelstrahlenbündel umzuformen. Eine derartige kollimierende Optik bedingt eine entsprechende Bauhöhe des Detektorteils. Alternativ angegebene Polarisationsdetektormittel beinhalten refraktive oder diffraktive Kleinlinsen mit nachgeschaltetem miniaturisiertem Polarisationsteilerwürfel. Solche miniaturisierten optischen Bauteile sind jedoch relativ aufwendig in der Herstellung.

In dem Zeitschriftenaufsatz J.S. Van Delden, Ortho-Babinet polarizationinterrogating filter: an interferometric approach to polarization measurement, Optics Letters, Band 28, Nr. 14, 15. Juli 2003, S. 1173 wird eine bildgebende Stokes-Polarimetrietechnik unter Verwendung eines OBPI-Filters beschrieben, mit der für quasi-parallel einfallende, bildgebende Strahlung alle vier Stokes-Parameter und damit der Polarisationszustand der Strahlung über das Bild hinweg ortsaufgelöst ohne bewegliche Teile bestimmt werden kann. Bei dieser OBPI-Methode wird nur eine einmalige Bildaufnahme benötigt, was auch als Schnappschuss("snapshot")-Polarimetrie bezeichnet wird. Das OBPI-Filter beinhaltet zwei Retarderelemente, die jeweils ein Paar uniaxialer, linear doppelbrechender Keilelemente umfassen und mit um 90° gegeneinander gedrehten Keilwinkeln hintereinander geschaltet sind, sowie einen nachgeschalteten Linearpolarisator. Die beiden doppelbrechenden Keilplattenretarder erzeugen eine in zwei Dimensionen räumlich linear ansteigende Änderung der Verzögerung von durchtretender Strahlung. Der nachgeschaltete Linearpolarisator wandelt diese Verzögerungsvariation in eine räumlich oszillierende Helligkeitsverteilung um. Es ergeben sich für vorgebbare, reine Polarisationszustände der einfallenden Strahlung unterschiedliche periodische Strukturmuster der Intensitätsverteilung, die als Basis- bzw. Referenzmuster dienen. Mit deren Hilfe kann dann der unbekannte Polarisationszustand eines Bildes einer niederaperturigen Abbildung bestimmt werden, indem durch ein geeignetes Auswerteverfahren aus dem gemessenen Strukturmuster die Anteile der verschiedenen Referenzmuster rekonstruiert werden. Wenn die Referenzmuster experimentell ermittelt werden, enthalten sie gleichzeitig auch etwaige instrumentell bedingte, nicht-ideale Einflüsse, so dass dadurch eine interne Kalibrierung gegeben ist.

Der Erfindung liegt als technisches Problem die Bereitstellung einer Vorrichtung der eingangs genannten Art zugrunde, mit der sich ein optisches System polarisationsspezifisch untersuchen lässt, insbesondere hinsichtlich der Beeinflussung des Polarisationszustands der verwendeten Strahlung durch das untersuchte optische System, und die sich mit vergleichsweise geringer Bauhöhe realisieren lässt und z.B. zur pupillenaufgelösten Ermittlung des polarisationsbedingten Einflusses auf die Abbildungsqualität bei hochaperturigen Mikrolithographie-Projektionsobjektiven verwendet werden kann. Weitere Ziele der Erfindung sind die Bereitstellung eines Kalibrierverfahrens für eine solche Vorrichtung und eines optischen Abbildungssystems, das abhängig von Messergebnissen einer solchen Vorrichtung betreibbar ist.

Die Erfindung löst dieses Problem durch die Bereitstellung einer Vorrichtung mit den Merkmalen des Anspruchs 1 oder 5, eines optischen Abbildungssystems mit den Merkmalen des Anspruchs 9 und eines Kalibrierverfahrens mit den Merkmalen des Anspruchs 10.

In einem ersten Aspekt der Erfindung beinhaltet die polarisationsspezifisch untersuchende Vorrichtung ein Polarisationsdetektormittel mit einer polarisierenden Gitterstruktur. Mit dem Begriff "polarisierende Gitterstruktur" ist hierbei eine periodische Struktur mit einer Periodizitätslänge bis etwa in der Größenordnung der Wellenlänge der verwendeten Strahlung gemeint, die polarisierende Eigenschaften zeigt. Solche polarisierende Gitterstrukturen werden auch Sub-λ-Gitter bezeichnet, wenn die Gitterstrukturperiode kleiner als die Strahlungswellenlänge ist. Zu weiteren Details über polarisierende Gitterstrukturen sei auf die diesbezügliche Fachliteratur verwiesen, siehe z.B. L. H. Cescato et al., "Holographic quarterwave plates", Applied Optics 29 (1990), Seite 3286, M. Totzeck et al., "Inspection of subwavelength structures and zero-order gratings using polarization-interferometry", Proceedings for Interferometry XI: Techniques and Analysis, SPIE 4777-39 (2002), M. Gruntman, "Transmission grating filtering of 52-140nm radiation", Applied Optics 36 (1997), Seite 2203, B. Schnabel et al., "Study on polarizing visible light by subwavelength-period metal-stripe gratings", Opt. Eng. 38 (1999), Seite 220 und M. Honkanen, "Inverse metal-stripe polarizers", Appl. Phys. B 68 (1999), Seite 81.

Die erfindungsgemäße Verwendung einer polarisierenden Gitterstruktur in den Polarisationsdetektormitteln ermöglicht eine vergleichsweise kompakte und einfache Realisierung des Detektorteils der Vorrichtung zur polarisationsspezifischen Untersuchung optischer Systeme. Insbesondere kann dadurch eine vorgeschaltete kollimierende Optik entfallen, und auch Kleinlinsen und miniaturisierte Polarisationsstrahlteilerelemente sind nicht zwingend erforderlich. Trotzdem eignet sich die Vorrichtung speziell auch zur pupillenaufgelösten Bestimmung der Beeinflussung des Polarisationszustands optischer Strahlung durch ein Mikrolithographie-Projektionsobjektiv hoher Apertur insbesondere auch im UV-Wellenlängenbereich, wobei der kompakt bauende Detektorteil problemlos auf der Bildseite des Projektionsobjektivs am Ort desselben in einer entsprechenden Mikrolithographie-Projektionsbelichtungsanlage platziert werden kann. Alle Aperturstrahlen können unter variierender Inzidenz auf die polarisierende Gitterstruktur analysiert werden, ohne dass eigens eine kollimierende Optik erforderlich ist. Im übrigen kann die Vorrichtung für diesen Anwendungszweck in einer der herkömmlichen Weisen aufgebaut sein, um das Objektiv durch eine entsprechende Technik zu vermessen, z.B. durch Scherinterferometrie, Punktbeugungsinterferometrie, nach dem Shack-Hartmann- oder dem Litel-Verfahren.

Insbesondere kann der Detektorteil der Vorrichtung dazu in Weiterbildung der Erfindung eine periodische Beugungsstruktur zur Bereitstellung eines entsprechenden Beugungseffektes umfassen. Die Beugungsstruktur kann z.B. durch ein Beugungsgitter realisiert sein, dessen Gitterperiodizität dann typischerweise deutlich größer als die Wellenlänge der verwendeten Strahlung ist und somit zwar beugende, aber keine merkliche polarisierende Wirkung hat. Im Fall eines untersuchten optischen Abbildungssystems kann vorteilhaft die periodische Beugungsstruktur im Wesentlichen in der Bildebene desselben und/oder die polarisierende Gitterstruktur bildebenennah angeordnet sein.

Die periodische Beugungsstruktur und die polarisierende Gitterstruktur können je nach Bedarf auf je einem eigenen Träger oder auf einem gemeinsamen Träger angeordnet sein, in letzterem Fall z.B. die eine Struktur auf einer Vorderseite und die andere Struktur auf einer Rückseite des gemeinsamen Trägers.

In vorteilhafter Ausgestaltung der Erfindung ist die Vorrichtung vom Scherinterferometrie-, Punktbeugungsinterferometrie-, Litel- oder Shack-Hartmann-Typ und/oder zur Bestimmung der Beeinflussung des Polarisationszustands optischer Strahlung durch ein mikrolithographisches Projektionsobjektiv eingerichtet.

In einem weiteren Aspekt umfasst die Erfindung eine Vorrichtung zur polarisationsspezifischen Untersuchung eines optischen Systems, insbesondere eines hochaperturigen optischen Abbildungssystems, mit Polarisationsdetektormitteln, die ein doppelbrechendes Element zur strahlwinkelabhängigen Verzögerungsvariation der aus dem optischen System austretenden Strahlung und mit einem nachgeschalteten Polarisatorelement beinhalten, das geeignet ist, auch solche Strahlung ausreichend zu polarisieren, die nicht quasi-parallel auf das doppelbrechende Element einfällt und aus diesem austritt. Mit dem Begriff "nicht quasi-parallel" ist hierbei Strahlung mit Einfallswinkeln von typischerweise mehr als 5° und insbesondere von bis ca. 60° und mehr gemeint, wie sie z.B. von einem hochaperturigen Abbildungssystem geliefert wird. Mit der Bezeichnung "ausreichend polarisieren" ist gemeint, dass das Polarisatorelement die vom doppelbrechenden Element kommende Strahlung mit einem Auslöschungsverhältnis polarisiert, das ausreichend groß ist, um aus der vom Polarisatorelement gelieferten Strahlung den Polarisationszustand der einfallenden Strahlung mit einer gewünschten, vorgebbaren Genauigkeit bestimmen zu können. Diese Vorrichtung eignet sich sehr vorteilhaft zur pupillenaufgelösten Schnappschuss-Polarimetrie an hochaperturigen Abbildungssystemen, z.B. Mikrolithographie-Projektionsobjektiven, ohne bewegliche Teile, speziell auch an hochaperturigen Abbildungssystemen, die mit UV-Strahlung arbeiten.

In einer Weiterbildung dieser Vorrichtung ist das dem doppelbrechenden Element nachgeschaltete Polarisatorelement ein polarisierendes Gitter. Dieses ist in der Lage, auch UV-Strahlung mit stark nicht-parallelen Einfallswinkeln, insbesondere UV-Strahlung aus einem hochaperturigen Abbildungssystem, mit ausreichendem Auslöschungsverhältnis zu polarisieren.

In beiden oben genannten Aspekten ermöglicht die Erfindung die polarisationsspezifische Untersuchung gerade auch von optischen Systemen, die mit Strahlung im Wellenlängenbereich unterhalb von etwa 400 nm und insbesondere im UV-Bereich von etwa 140 nm bis etwa 200 nm oder unterhalb von 140 nm arbeiten. Zur polarisationsspezifischen Untersuchung hochaperturiger Abbildungssysteme ist dabei insbesondere der Einsatz des polarisierenden Gitters als Polarisatorelement zweckmäßig.

In einem weiteren Aspekt stellt die Erfindung ein optisches Abbildungssystem, insbesondere für eine Mikrolithographie-Projektionsbelichtungsanlage, bereit, dem eine erfindungsgemäße Vorrichtung zur polarisationsspezifischen Untersuchung als Teil eines Regelkreises zugeordnet ist, mit dem wenigstens ein optisches Element des Abbildungssystems in Abhängigkeit von einem Messresultat der Polarisationsuntersuchungsvorrichtung eingestellt wird. Dies ermöglicht eine Nachregulierung des Abbildungssystems in Reaktion auf die gemessene Beeinflussung des Polarisationszustands der im Abbildungsbetrieb verwendeten Strahlung im Betriebseinsatz des Abbildungssystems.

Die Erfindung umfasst des weiteren ein geeignetes Kalibrierverfahren für die erfindungsgemäße Polarisationsuntersuchungsvorrichtung, bei der die Polarisationsdetektormittel das doppelbrechende Element und das nachgeschaltete Polarisatorelement umfassen, speziell für den Einsatz dieser Vorrichtung bei der Untersuchung eines hochaperturigen Abbildungssystems. Dazu werden bei einem quasi-parallelen Kalibrierstrahlenbündel nacheinander verschiedene definierte Polarisationszustände eingestellt, und das Kalibrierstrahlenbündel wird durch eine hochaperturige Optik umgeformt. Für jeden eingestellten Polarisationszustand wird das sich daraus ergebende Strukturmusterbild erfasst, so dass die so ermittelten Strukturmusterbilder als Referenz bei der Auswertung von Strukturmusterbildern dienen können, die mit Hilfe der Polarisationsuntersuchungsvorrichtung für unbekannte Polarisationszustände von Strahlung gemessen werden, die z.B. von einem hochaperturigen Mikrolithographie-Projektionsobjektiv geliefert wird. Das Kalibrierverfahren kann experimentell oder durch eine Simulation ausgeführt werden.

Vorteilhafte Ausführungsformen der Erfindung sind in den Zeichnungen dargestellt und werden nachfolgend beschrieben. Hierbei zeigen:
- Fig. 1: eine schematische Seitenansicht des erfindungswesentlichen Teils einer Vorrichtung zur polarisationsspezifischen Untersuchung eines optischen Systems unter Verwendung eines Detektorteils mit einer periodischen Beugungsstruktur und einer polarisierenden Gitterstruktur auf je einem eigenen Strukturträger,
- Fig. 2: eine Darstellung entsprechend Fig. 1 für eine Variante mit gemeinsamem Träger für die periodische Beugungsstruktur und die polarisierende Gitterstruktur,
- Fig. 3: eine Darstellung entsprechend Fig. 1 für eine Variante, die eine Schnappschuss-Polarimetrie ermöglicht und ein doppelbrechendes Element sowie eine polarisierende Gitterstruktur umfasst, und
- Fig. 4: eine schematische Seitenansicht einer Anordnung zur Kalibrierung der Vorrichtung von Fig. 3.

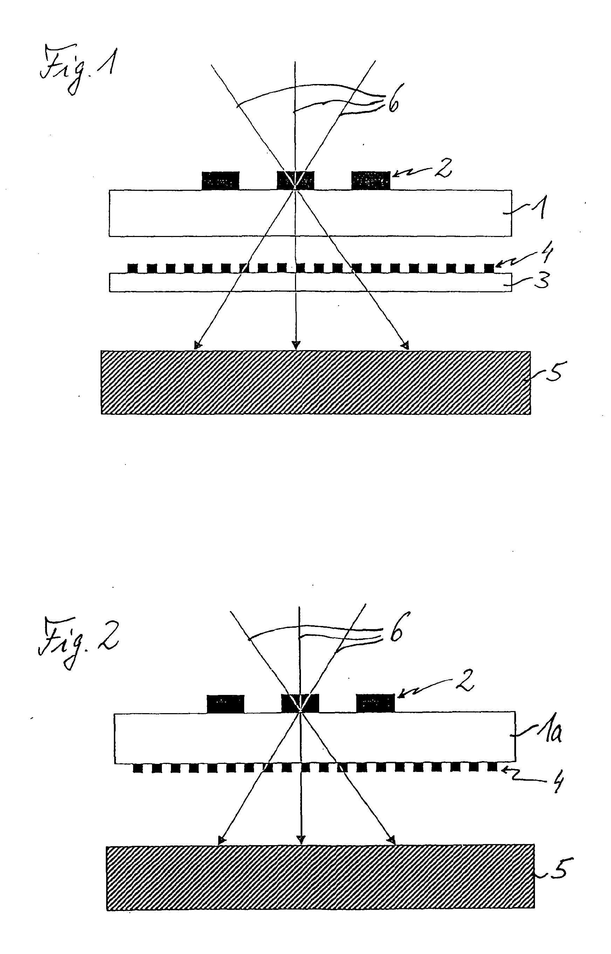

Fig. 1 zeigt den vorliegend besonders interessierenden Teil einer Vorrichtung zur polarisationsspezifischen Untersuchung eines optischen Systems, wobei die Vorrichtung speziell darauf ausgelegt sein kann, die Beeinflussung des Polarisationszustands optischer Strahlung durch ein Mikrolithographie-Projektionsobjektiv hoher Apertur pupillenaufgelöst zu bestimmen. Genauer gesagt zeigt Fig. 1 einen im Fall der Untersuchung eines optischen Abbildungssystems auf der Bildseite desselben angeordneten Vorrichtungsteil mit einem Detektorteil, der spezielle Polarisationsdetektormittel beinhaltet.

Im einzelnen beinhaltet der in Fig. 1 gezeigte Vorrichtungsteil einen ersten Gitterträger 1 mit einer auf seiner Vorderseite angeordneten Beugungsgitterstruktur 2, einen zweiten Gitterträger 3 mit einer auf dessen Vorderseite angeordneten polarisierenden Gitterstruktur 4 und ein Detektorelement 5, das z.B. durch einen CCD-Chip einer Bildaufnahmekamera gebildet sein kann. Der erste Träger 1 mit der Beugungsgitterstruktur 2, der zweite Träger 3 mit der polarisierenden Gitterstruktur 4 und das Detektorelement 5 sind hintereinander im Strahlengang von zu analysierender Strahlung 6 angeordnet, die aus dem zu untersuchenden optischen System austritt.

In einer bevorzugten Realisierung dient die Vorrichtung gemäß Fig. 1 der pupillenaufgelösten Vermessung eines mikrolithographischen Projektionsobjektivs mittels Scherinterferometrie unter Verwendung von Strahlung der gleichen Wellenlänge, wie sie in der zugehörigen Projektionsbelichtungsanlage im normalen Belichtungsbetrieb z.B. zur Waferbelichtung eingesetzt wird, d.h. als BIF. Der Übersichtlichkeit halber sind in Fig. 1 das Projektionsobjektiv und der auf dessen Objektseite befindliche Teil der Vermessungsvorrichtung nicht dargestellt, wobei der objektseitige Vorrichtungsteil einen herkömmlichen, vom gewählten Vermessungsverfahren abhängigen Aufbau besitzt, der folglich keiner näheren Erläuterung bedarf. Es kann hierzu beispielsweise auf die erwähnte ältere deutsche Patentanmeldung 103 04 822.7 verwiesen werden.

Im besagten Anwendungsfall der Objektivvermessung durch Scherinterferometrie fungiert das Beugungsgitter 2 als zugehörige Scherinterferometrie-Beugungsstruktur, wozu es bevorzugt eine gegenüber der Wellenlänge der verwendeten Strahlung 6 deutlich größere Gitterperiodizität besitzt, wie dem Fachmann bekannt. Im Unterschied dazu besitzt die polarisierende Gitterstruktur 4 eine Gitterperiodizität maximal in der Größenordnung der verwendeten Strahlungswellenlänge. Derartige polarisierende Gitterstrukturen sind in der Praxis auch für typische UV-Strahlungswellenlängen hochauflösender Mikrolithographie-Projektionsbelichtungsanlagen, wie im Bereich von etwa 140nm bis 200nm, realisierbar, z.B. durch eine Gitterstruktur aus Gold mit ca. 90nm bis 100nm Dicke und einer Gitterperiodizität von ebenfalls etwa 90nm bis 100nm auf einem dünnen Quarzträger oder durch ein freitragendes Nickelgitter mit einer Dicke und Periodizität der Nickelmetallstreifen von jeweils ca. 100nm, was Strukturbreiten von ca. 50nm bedeutet.

Die Scherinterferometrie-Beugungsstruktur 2 wird, wie in Fig. 1 anhand eines Mitten- und zweiter Randstrahlen der Strahlung 6 illustriert, vorzugsweise in der Bildebene des untersuchten Objektivs angeordnet, während die polarisierende Gitterstruktur 4 mit geringem Abstand davon zwischen dem Beugungsgitter 2 und dem Detektorelement 5 platziert ist. Je nach Bedarf und Anwendungsfall sind andere Positionierungen der beiden periodischen Strukturen 2, 4 möglich, wobei die polarisierende Gitterstruktur 4 statt wie gezeigt hinter alternativ auch vor der Beugungsstruktur 2 angeordnet sein kann.

Wie aus Fig. 1 ersichtlich, benötigt die gezeigte Vorrichtung im Detektorteil außer der polarisierenden Gitterstruktur 4 keine weiteren Optikkomponenten zwischen der Beugungsstruktur 2 und dem Detektorelement 5, insbesondere keine kollimierenden Optikbauteile. Dies ermöglicht einen kompakten Aufbau des Detektorteils mit geringer Bauhöhe, so dass der Detektorteil ohne Bauraumprobleme auf der Bildseite des untersuchten Objektivs platziert werden kann, insbesondere auch an Ort und Stelle des Projektionsobjektivs in der zugehörigen Projektionsbelichtungsanlage. Alle Aperturstrahlen des typischerweise eine relativ hohe numerische Apertur besitzenden Projektionsobjektivs mit Aperturwinkeln von bis zu 60° und mehr können unter variierender Inzidenz auf das polarisierende Gitter 4 vom nachgeschalteten Detektorelement 5 erfasst und von einer zugehörigen herkömmlichen, nicht gezeigten Auswerteeinheit pupillenaufgelöst analysiert werden.

Untersuchungen zeigen, dass mit einer solchen Vorrichtung mit polarisierendem, bei hohen Inzidenzwinkeln arbeitendem Gitter 4 im Detektorteil z.B. eine Ermittlung der Jones-Matrix mit ausreichender Genauigkeit möglich ist, speziell auch für die erwähnten, für die Mikrolithographie besonders interessierenden UV-Wellenlängen im Bereich zwischen etwa 140 nm und 200nm.

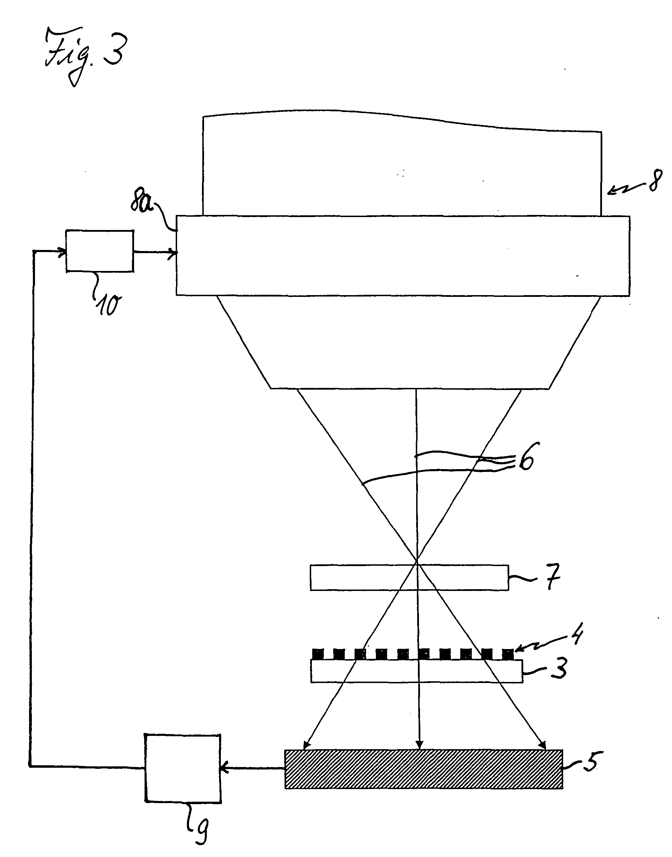

Fig. 2 zeigt eine Variante der Vorrichtung von Fig. 1, die sich von dieser darin unterscheidet, dass die Beugungsstruktur 2 und die polarisierende Gitterstruktur 4 auf einem gemeinsamen Träger 1a angeordnet sind, wobei für funktionell äquivalente Elemente gleiche Bezugszeichen gewählt sind und insoweit auf die obige Beschreibung der Fig. 1 verwiesen werden kann.

Im gezeigten Beispiel von Fig. 2 befindet sich die Beugungsstruktur 2 an der Vorderseite und die polarisierende Gitterstruktur 4 an der Rückseite des gemeinsamen Trägers 1a. Zur Herstellung kann beispielsweise zunächst die Beugungsstruktur 2 an der Vorderseite des Trägers 1a erzeugt und anschließend das polarisierende Gitter 4 als vorgefertigte Struktur an der Rückseite des Trägers 1a, z.B. durch Ansprengen fixiert werden.

Im übrigen ergeben sich für die Vorrichtung von Fig. 2 ersichtlich dieselben Eigenschaften, Verwendungsmöglichkeiten und Vorteile wie oben zur Vorrichtung von Fig. 1 erwähnt, worauf verwiesen werden kann.

Exemplarisch wurde oben der Einsatz der erfindungsgemäßen Vorrichtung zur polarisationsspezifischen, pupillenaufgelösten Scherinterferometrie-Vermessung eines hochaperturigen Mikrolithographie-Projektionsobjektivs erläutert. Es versteht sich jedoch, dass sich die erfindungsgemäße Vorrichtung bei entsprechenden Auslegung auch für jedwede anderen polarisationsspezifischen Untersuchungen von Objektiven und anderen optischen Systemen eignet. Insbesondere kann die Vorrichtung mit dem kompakt zu bauenden Detektorteil mit polarisierendem Gitter auch dafür ausgelegt sein, ein Mikrolithographie-Projektionsobjektiv oder ein anderes optisches Abbildungssystem unter Verwendung des Punktbeugungsinterferometrie-, Shack-Hartmann- oder Litel-Verfahrens hinsichtlich Abbildungsfehlern zu vermessen bzw. zu korrigieren.

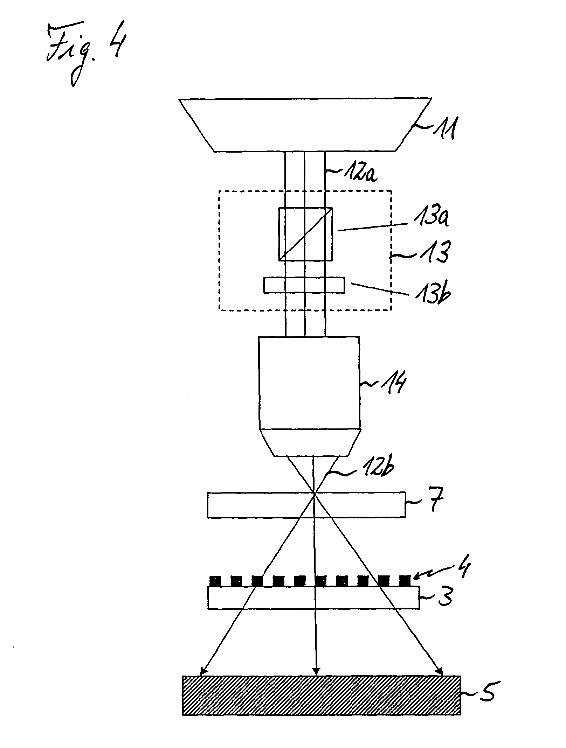

Fig. 3 zeigt eine weitere Vorrichtung zur polarisationsspezifischen Untersuchung eines optischen Systems, die sich für eine Schnappschuss-Polarimetrie ohne bewegliche Teile eignet. Die Vorrichtung von Fig. 3 entspricht in ihrem Aufbau, ihrer Funktionsweise und den damit verbundenen Vorteilen in gewissem Maß der Vorrichtung von Fig. 1, so dass insoweit auf deren obige Beschreibung verwiesen werden kann, soweit nachstehend nichts anderes gesagt ist.

Im Unterschied zur Vorrichtung von Fig. 1 weist die Vorrichtung von Fig. 3 anstelle der Beugungsgitterstruktur 2 ein einfaches doppelbrechendes Element 7 auf, z.B. eine doppelbrechende Planplatte. Dieses doppelbrechende Element 7 bewirkt eine zweidimensionale Variation der Verzögerung des hochaperturigen Strahlenbündels 6, das aus einem hier gezeigten, hochaperturigen Abbildungssystem 8 bildgebend austritt. Bei dem Abbildungssystem 8 kann es sich wiederum insbesondere um ein Mikrolithographie-Projektionsobjektiv hoher Apertur handeln. Dem doppelbrechenden Element 7 nachgeschaltet beinhaltet die Vorrichtung von Fig. 3 wie diejenige von Fig. 1 die polarisierende Gitterstruktur 4 auf dem Gitterträger 3 und das Detektorelement 5.

Die Funktionsweise der Vorrichtung von Fig. 3 und die Auswertung der von dieser Vorrichtung mittels Schnappschuss-Polarimetrie durch eine einzige Bildaufnahme ohne bewegliche Teile erhältlichen Polarisationszustands-Messergebnisse entsprechen der Funktionsweise und dem Auswerteverfahren der OBPI-Methode, wie sie in dem oben erwähnten Zeitschriftenaufsatz von J.S. Van Delden und der dort zitierten Literatur beschrieben sind, worauf vorliegend für weitere Details verwiesen werden kann und wozu der Inhalt dieses Zeitschriftenaufsatzes hierin in vollem Umfang durch Verweis aufgenommen wird. Im Unterschied zu der dort beschriebenen Vorrichtung ist jedoch die Vorrichtung von Fig. 3 auch zur Polarisationszustandsbestimmung für Strahlung mit merklich nicht-parallelen Einfallswinkeln, wie dem aus dem hochaperturigen Abbildungssystem 8 austretenden, bilderzeugenden Strahlenbündel 6, geeignet und ausgelegt. Darunter sind Einfallswinkel von mindestens ca. 5° und typischerweise bis zu 60° oder mehr zu verstehen, wie sie z.B. bei hochaperturigen Mikrolithografie-Projektionsobjektiven vorliegen. Die Vorrichtung von Fig. 3 eignet sich insbesondere auch für Strahlung im UV-Wellenlängenbereich, z.B. mit Wellenlängen zwischen etwa 140 nm und etwa 200 nm oder unterhalb von 140 nm, wie sie zunehmend bei Mikrolithographie-Projektionsbelichtungsanlagen als Belichtungsstrahlung verwendet wird.

Das Strahlenbündel 6 eines vom hochaperturigen Abbildungssystem 8 erzeugten, punktförmigen Bildes durchläuft das stark doppelbrechende Element 7. Durch dieses erfährt die Strahlung 6 eine Variation seiner Verzögerung, da sich die Wegstrecke und die Orientierung für die verschiedenen Strahlen bezüglich der Hauptachsen des doppelbrechenden Elements 7 abhängig vom Strahlwinkel ändern. Durch das nachgeschaltete Polarisatorelement in Form des polarisierenden Gitterelementes 3, 4 wird die Verzögerungsvariation wie bei der herkömmlichen OBPI-Methode in eine Helligkeitsmodulation umgewandelt, so dass in der Bildebene ein vom Polarisationszustand abhängiges Strukturmuster entsteht, das vom Detektorelement 5 aufgenommen wird. Das Polarisatorelement 3, 4 ist so ausgelegt, dass es die Strahlung auch unter den hier vorliegenden, vergleichsweise hohen Einfallswinkeln mit hinreichendem Auslöschungsverhältnis polarisiert. Speziell im UV-Wellenlängenbereich ist hierzu die polarisierende Gitterstruktur 4 in der Lage, während kristalloptische Komponenten typischerweise nur bis zu Einfallswinkeln von höchstens etwa 5° mit ausreichendem Auslöschungsverhältnis polarisieren können. Die Auswertung der vom Detektorelement 5 aufgenommenen Strukturmuster erfolgt dann wie bei der herkömmlichen OBPI-Methode, worauf verwiesen werden kann und was daher hier keiner weiteren Erläuterung bedarf. Da die Änderung der Einfallswinkel am doppelbrechenden Element 7 in der Nähe des Mittelstrahls viel geringer ist als in der Nähe von Randstrahlen, ergeben sich im Unterschied zur OBPI-Methode räumlich merklich inhomogene Strukturmuster in der Bildebene. Bei Bedarf kann dies korrigiert werden, z.B. durch eine rechnerische Entzerrung mit einem dem Fachmann geläufigen Entzerrungsalgorithmus.

Als Detektorelement 5 eignet sich z.B. wie bei der Vorrichtung von Fig. 1 ein CCD-Element einer Bildaufnahmekamera. Alternativ ist ein Photofilm verwendbar, der belichtet wird, wonach die auf ihm erzeugten Strukturmusterbilder geeignet ausgewertet werden. Die Verwendung dieser Variante ist bei der Vorrichtung von Fig. 3 dadurch erleichtert, dass gemäß der Schnappschuss-Polarimetrietechnik nur eine einzige Bildaufnahme erforderlich ist. Je nach verwendetem Wellenlängenbereich der Strahlung sind statt der polarisierenden Gitterstruktur 4 auch andere Polarisatorelemente verwendbar, die geeignet sind, die vom doppelbrechenden Element austretende Strahlung auch für merklich nicht-parallele Einfallswinkel ausreichend zu polarisieren.

Die Vorrichtung von Fig. 3 ermöglicht somit eine bildgebende, pupillenaufgelöste Stokes-Polarimetrie über die gesamte Pupille eines hochaperturigen Abbildungssystems in sehr kompakter Bauweise mit sehr einfacher Bildaufnahmeprozedur, für die eine einzige Belichtung genügt, ohne dass bewegliche Komponenten oder Mikroskopoptiken oder eine zusätzliche ellipsometrische Messung an mindestens einem Strahl, z.B. dem Achsstrahl, zwingend erforderlich sind. Die Durchführung der zugehörigen Auswertealgorithmik ist mit den typischerweise verfügbaren Rechnerleistungen unproblematisch, auf welche die Regel-/Auswerteeinheit 9 entsprechend ausgelegt ist.

In Fig. 3 ist des weiteren die Verwendung der Polarisationszustandsuntersuchungsvorrichtung in einem Regelkreis für das Abbildungssystem 8 veranschaulicht. Der Regelkreis beinhaltet eine Regel-/Auswerteeinheit 9, der das Messsignal des Detektorelements 5 zugeführt wird und die es in der erwähnten Weise auswertet. Abhängig von der dadurch ermittelten Beeinflussung des Polarisationszustands der Strahlung 6 durch das Abbildungssystem 8 steuert die Regel-/Auswerteeinheit 9 eine Manipulatoreinheit 10 des Abbildungssystems 8 an. Die Manipulatoreinheit 10 beinhaltet einen oder mehrere Manipulatoren zur Einstellung einer oder mehrerer einstellbarer Komponenten 8a des Abbildungssystems 8. Im Fall eines Mikrolithographie-Projektionsobjektivs 8 können dies ein oder mehrere xy- und/oder z-Manipulatoren zur Einstellung von Linsenelementen des Objektivs 8 in der z-Richtung parallel zur optischen Achse bzw. in der dazu senkrechten xy-Querebene sein. Auf diese Weise kann das Abbildungssystem 8 während seines Abbildungsbetriebseinsatzes bei Bedarf in seinen Abbildungseigenschaften unter Berücksichtigung seines Einflusses auf den Polarisationszustand der zur Abbildung verwendeten Strahlung 6 nachgeregelt werden. Es versteht sich, dass bei Bedarf anstelle der Vorrichtung von Fig. 3 auch die Vorrichtung von Fig. 1 in dieser Weise in einen Regelkreis für das Abbildungssystem 8 integriert sein kann.

Fig. 4 veranschaulicht eine Kalibriertechnik für die Vorrichtung von Fig. 3. Wie in Fig. 4 veranschaulicht, wird hierzu durch ein geeignetes, herkömmliches Beleuchtungssystem 11 ein quasi-paralleles Strahlenbündel 12a bereitgestellt, dessen Wellenlänge der Betriebswellenlänge der zu kalibrierenden Polarisationsuntersuchungsvorrichtung bzw. des von dieser vermessenen Abbildungssystems 8 entspricht.

Durch einen Polarisationszustandsgenerator 13 wird ein beliebiger, definierter Polarisationszustand für das Strahlenbündel 12a eingestellt. Dazu umfasst der Polarisationszustandsgenerator 13 z.B. einen drehbaren Polarisationsstrahlteiler 13a und eine drehbare Verzögerungsplatte 13b herkömmlicher Art. Anschließend wird das solchermaßen in seinem Polarisationszustand definierte, quasi-parallele Strahlenbündel mittels einer geeigneten hochaperturigen Optik 14, z.B. eines Mikroskopobjektivs, in ein entsprechendes konvergentes Strahlenbündel 12b umgeformt. Letzteres wird in die Polarisationsuntersuchungsvorrichtung eingekoppelt, d.h. auf das doppelbrechende Element 7 eingestrahlt, um anschließend das polarisierende Gitter 3, 4 zu durchlaufen und auf das Detektorelement 5 zu fallen. Das vom Detektorelement 5 aufgenommene Strukturmuster dient dann als zum eingestellten Polarisationszustand gehöriges Referenzmuster.

Der Kalibriervorgang wird für verschiedene definierte Polarisationszustände wiederholt, die mit dem Polarisationszustandsgenerator 13 eingestellt werden, so dass nach Abschluss dieses Kalibriervorgangs ein Satz von Referenzmustern vorhanden ist, die zu den verschiedenen vorgegebenen Polarisationszuständen gehören. Diese Referenzmuster können dann bei der Auswertung der vom Detektorelement 5 aufgenommenen Strukturmuster im Messbetrieb der Vorrichtung von Fig. 3, d.h. bei der Rekonstruktion des gesuchten, vom Abbildungssystem 8 verursachten Polarisationszustandseinflusses, herangezogen werden, entsprechend dem Auswerteverfahren bei der herkömmlichen OBPI-Methode.

Anstelle des beschriebenen experimentellen Kalibrierverfahrens können die zur Auswertung erforderlichen Strukturmusterbilder für definierte Polarisationszustände auch durch eine rechnerische Simulation bestimmt werden, falls die polarisationsoptischen Eigenschaften der in der Vorrichtung verwendeten optischen Komponenten hinreichend genau bekannt sind.

Bei Bedarf kann eine eventuell vorhandene, nicht-rotationssymmetrische Polarisationsbeeinflussung durch das Mikroobjektiv 14 bei der Kalibrierung der Polarisationsuntersuchungsvorrichtung durch Ausmitteln eliminiert werden. Dazu werden für einen jeweils eingestellten Polarisationszustand mehrere Kalibriermessungen bei verschiedenen Drehstellungen des Mikroobjektivs 14 bezüglich seiner optischen Achse ausgeführt und die Ergebnisse dieser Messvorgänge gemittelt.

## Patentansprüche

1. Vorrichtung zur polarisationsspezifischen Untersuchung eines optischen Systems, insbesondere zur Bestimmung der Beeinflussung des Polarisationszustands optischer Strahlung durch ein optisches Abbildungssystem, mit
- einem Detektorteil mit Polarisationsdetektormitteln (4, 5) zur Erfassung des Austritts-Polarisationszustands von aus dem optischen System austretender Strahlung (6),
**dadurch gekennzeichnet, dass**
- die Polarisationsdetektormittel eine polarisierende Gitterstruktur (4) beinhalten.

2. Vorrichtung nach Anspruch 1, weiter **dadurch gekennzeichnet, dass** der Detektorteil eine periodische Beugungsstruktur (2) umfasst, wobei die polarisierende Gitterstruktur (4) im Strahlengang vor oder hinter der periodischen Beugungsstruktur (2) angeordnet ist.

3. Vorrichtung nach Anspruch 2, weiter **dadurch gekennzeichnet, dass** die Vorrichtung zur polarisationsspezifischen Untersuchung eines optischen Abbildungssystems eingerichtet ist und dass die periodische Beugungsstruktur (2) im wesentlichen in der Bildebene des Abbildungssystems und/oder die polarisierende Gitterstruktur (4) bildebenennah angeordnet ist.

4. Vorrichtung nach Anspruch 2 oder 3, weiter **dadurch gekennzeichnet, dass** die polarisierende Gitterstruktur (4) und die periodische Beugungsstruktur (2) auf einem gemeinsamen Träger (1a) angeordnet sind, wobei die eine der beiden Strukturen (2, 4) auf einer Trägervorderseite und die andere auf einer Trägerrückseite angeordnet sind.

5. Vorrichtung nach einem der Ansprüche 1 bis 4, weiter **dadurch gekennzeichnet, dass** sie vom Scherinterferometrie-, Punktbeugungsinterferometrie-, Shack-Hartmann- oder Litel-Typ ist und/oder zur pupillenaufgelösten Bestimmung der Beeinflussung des Polarisationszustands optischer Strahlung durch ein mikrolithographisches Projektionsobjektiv eingerichtet ist.

6. Vorrichtung zur polarisationsspezifischen Untersuchung eines optischen Systems, insbesondere zur Bestimmung der Beeinflussung des Polarisationszustands optischer Strahlung durch ein hochaperturiges optisches Abbildungssystem, mit
- einem Detektorteil mit Polarisationsdetektormitteln (4, 5, 7) zur Erfassung des Austritts-Polarisationszustands von aus dem optischen System austretender Strahlung (6),
**dadurch gekennzeichnet, dass**
- die Polarisationsdetektormittel ein doppelbrechendes Element (7) zur strahlwinkelabhängigen Verzögerungsvariation der aus dem optischen System austretenden Strahlung und ein nachgeschaltetes Polarisatorelement (4) beinhalten, das geeignet ist, auch nicht quasi-parallele, vom doppelbrechenden Element kommende Strahlung mit nicht-parallelen Einfallswinkeln ausreichend zu polarisieren.

7. Vorrichtung nach Anspruch 6, weiter **dadurch gekennzeichnet, dass** das Polarisatorelement eine polarisierende Gitterstruktur (4) beinhaltet.

8. Vorrichtung nach einem der Ansprüche 1 bis 7, weiter **dadurch gekennzeichnet, dass** die Wellenlänge der optischen Strahlung (6) im Bereich unterhalb von etwa 400 nm, insbesondere im Bereich von etwa 140 nm bis etwa 200 nm oder unterhalb von 140 nm, liegt.

9. Optisches Abbildungssystem, insbesondere für eine Mikrolithographie-Projetionsbelichtungsanlage, mit
- einem oder mehreren optischen Elementen (8a), von denen wenigstens eines variabel einstellbar ist,
- einer Vorrichtung nach einem der Ansprüche 1 bis 8 zur polarisationsspezifischen Untersuchung des Abbildungssystems und
- einem Regelkreis (9, 10) zur Einstellung des wenigstens einen einstellbaren optischen Elements (8a) in Abhängigkeit von einem Messresultat der Vorrichtung zur polarisationsspezifischen Untersuchung des Abbildungssystems.

10. Verfahren zur Kalibrierung der Vorrichtung mit den Merkmalen nach Anspruch 6 oder bis 7 mit folgenden Schritten:
a) Bereitstellen eines quasi-parallelen Kalibrierstrahlenbündels (12a) mit einem eingestellten Polarisationszustand,
b) Umformen des quasi-parallelen Kalibrierstrahlenbündels in ein konvergentes Kalibrierstrahlenbündel (12b), das in die Polarisationsuntersuchungsvorrichtung eingekoppelt wird, durch eine hochaperturige Optik (14),
c) Erfassen des für den eingestellten Polarisationszustand durch die Polarisationsuntersuchungsvorrichtung erzeugten Strukturmusterbildes und Verwenden desselben als kalibrierendes Referenzmuster und
d) ein- oder mehrmaliges Wiederholen der Schritte a bis c für jeweils einen anderen eingestellten Polarisationszustand.
